**Europäisches Patentamt**

**European Patent Office**

**Office européen des brevets**

(19)

(11) Veröffentlichungsnummer : **0 032 999**
**B1**

(12) # EUROPÄISCHE PATENTSCHRIFT

(45) Veröffentlichungstag der Patentschrift :
**15.05.85**

(21) Anmeldenummer : **80107861.9**

(22) Anmeldetag : **12.12.80**

(51) Int. Cl.⁴ : **H 01 L 21/00, H 01 L 21/314**

(54) Verfahren zum Herstellen einer bipolaren, vertikalen Transistorstruktur.

(30) Priorität : **25.01.80 US 115307**

(43) Veröffentlichungstag der Anmeldung :
**05.08.81 Patentblatt 81/31**

(45) Bekanntmachung des Hinweises auf die Patenterteilung : **15.05.85 Patentblatt 85/20**

(84) Benannte Vertragsstaaten :
**DE FR GB IT**

(56) Entgegenhaltungen :
**EP-A- 0 004 292**
**EP-A- 0 005 721**
**US-A- 3 648 125**
**US-A- 4 115 797**
**US-A- 4 160 991**

(73) Patentinhaber : **International Business Machines Corporation**
**Old Orchard Road**
**Armonk, N.Y. 10504 (US)**

(72) Erfinder : **Anantha, Narasipur Gundappa**
**1 Valdemar Rd.**
**Hopewell Junction, N.Y. 12533 (US)**
Erfinder : **Bhatia, Harsaran Singh**
**41 Tor Road**
**Wappinger Falls, N.Y. 12590 (US)**
Erfinder : **Walsh, James Leo**
**23 South Drive**
**Hyde Park N.Y. 12538 (US)**

(74) Vertreter : **Gaugel, Heinz, Dipl.-Ing.**
**Schönaicher Strasse 220**
**D-7030 Böblingen (DE)**

EP 0 032 999 B1

**Beschreibung**

Die Erfindung betrifft ein Verfahren zum Herstellen einer bipolaren, vertikalen Transistorstruktur, bei dem in einem in einer Halbleiterschicht durch Isolationszonen abgegrenzten, als Kollektorzone dienenden Bereich eine intrinsische und eine diese lateral umgebende extrinsische Basiszone und in der intrinsischen Basiszone eine Emitterzone verwirklicht werden und bei dem die Emitter- und die Kollektorzone direkt und die Basiszone über eine dotierte polykristalline Siliciumschicht kontaktiert werden.

Aus der US Patentschrift Nr. 4 160 991 ist bereits eine bipolare Halbleiterstruktur und ein Verfahren zum Herstellen dieser Struktur bekannt, bei dem die Basiszone mittels einer polykristallinen Siliciumschicht kontaktiert wird. Über dieser polykristallinen Siliciumschicht liegt eine Oxidschicht, die den Emitterkontakt vom Basiskontakt trennt. Auf diese Weise erreicht man, daß Emitter- und Basiszone lediglich einen Abstand voneinander aufweisen, der der Dicke der genannten Oxidschicht entspricht. Es lassen sich auf diese Weise Abstände zwischen Basis- und Emitterzone von etwa 0,5 μm erreichen. Diese geringen Abstände bewirken, daß der Basiswiderstand reduziert und die Schaltgeschwindigkeit des Bauelementes erhöht wird.

Obwohl bei dieser Methode die genannte Abstandsverringerung stattfindet, so ist doch festzustellen, daß die Emitterzone in bezug auf die Basiszone nicht automatisch ausgerichtet ist. Dies hat zur Folge, daß die Injektion aus der Emitterzone nicht allseitig optimal gleichförmig in die umgebende Basiszone erfolgt. Außerdem sind bei diesen bekannten Verfahren keinerlei Hinweise auf Störstellenkonzentrationen angegeben, die eine intrinsische und eine extrinsische Basiszone betreffen.

Hier will die Erfindung Abhilfe schaffen. Die Erfindung, wie sie in den Ansprüchen gekennzeichnet ist, löst die Aufgabe, ein Verfahren zum Herstellen einer bipolaren, vertikalen Transistorstruktur anzugeben, bei dem automatisch aufeinander ausgerichtete Basis- und Emitterzonen gebildet werden, die bei optimaler Kontaktierbarkeit minimale Abstände voneinander aufweisen.

Durch das erfindungsgemäße Verfahren ist eine gleichförmige Ladungsträgerinjektion aus der Emitterzone in die angrenzende Basiszone gewährleistet. Die Basiszone weist einen extrem geringen Basiswiderstand auf, was für das Erreichen hoher Schaltgeschwindigkeiten des Transistors ausschlaggebend ist.

Zusammenfassend wird die Erfindung in einem Verfahren zum Herstellen einer bipolaren vertikalen Transistorstruktur darin gesehen, daß durch automatisches Ausrichten der Emitterzone auf die Basiszone eine gleichförmige Ladungsträgerinjektion aus der Emitterzone und gleichzeitig ein extrem geringer Abstand des Basis- und Emitterkontaktes gewährleistet wird, wobei eine unabhängige Dotierung einer extrinsischen und einer intrinsischen Basiszone und eine Kontaktierung der extrinsischen Basiszone über eine dotierte polykristalline Siliciumschicht erfolgt.

Dazu wird eine dotierte, polykristalline Siliciumschicht auf eine mehrschichtige Maskierungsschicht aufgedampft, die den die Emitterzone, die intrinsische Basiszone und die diese umgebende extrinsische Basiszone umfassenden Oberflächenbereich einer Halbleiterschicht abdeckt. Beim Aufdampfen der polykristallinen Siliciumschicht setzt sich an den Seitenflächen dieser Maskierungsschicht kein Silicium ab. Das auf der Oberfläche der Maskierungsschicht abgeschiedene polykristalline Silicium wird entfernt. Anschließend wird die Maskierungsschicht so unterätzt, daß der Oberflächenbereich der die extrinsische Basiszone umfassenden Halbleiterschicht freigelegt wird. Unter Benutzung der unterätzten Maskierungsschicht als Maske wird die extrinsische Basiszone in die Halbleiterschicht eingebracht und dieser Oberflächen bereich mit einer Oxidschicht abgedeckt. Der verbliebene Teil der Maskierungsschicht wird dann entfernt und die Emitterzone eingebracht. Die Kontaktierung erfolgt über die seitlich an die extrinsische Basiszone heranreichende polykristalline Siliciumschicht.

Im folgenden wird die Erfindung anhand von lediglich einem Ausführungsweg darstellenden Zeichnungen näher erläutert.

Es zeigen

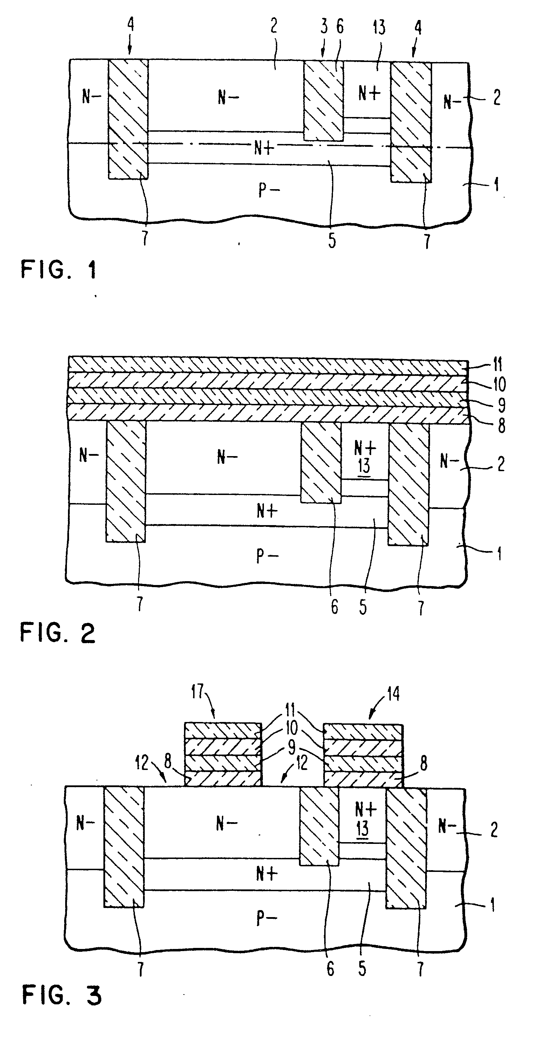

Figuren 1 bis 9 vereinfachte Schnittansichten einer nach dem erfindungsgemäßen Verfahren hergestellten Transistorstruktur in aufeinanderfolgenden Schritten des Verfahrens.

Wie die Fig. 1 zeigt, wird von einem P-leitenden Halbleitersubstrat ausgegangen, in das eine nicht in ihrer gesamten Ausdehnung dargestellte, N⁺-dotierte Zone 5 durch Diffusionen oder Ionenimplantation in konventioneller eingebracht wird. Auf die Oberfläche des Substrats 1 wird anschließend eine N-dotierte Epitaxieschicht 2 aufgebracht, die eine bestimmte Dicke, vorzugsweise eine Dicke von weniger als 2 μm aufweist.

Die auf diese Weise erhaltene Struktur wird einer Reihe von selektiven Ionen-Ätzschritten ausgesetzt, bei denen flache Gräben, wie im Gebiet 3, und tiefe Gräben, wie im Gebiet 4, gebildet werden. Es ist zu bemerken, daß die tiefen Gräben sich durch die N⁺-dotierte Zone 5 hindurch erstrecken und somit eine Reihe von N⁺-Subkollektoren, wie beispielsweise den Subkollektor 5, abgrenzen. Die flachen Gräben erstrecken sich nur bis zu diesen Subkollektorzonen 5. Nach dem Ätzen der genannten Gräben werden diese auf pyrolitischem Wege mit Siliciumdioxid gefüllt. Der Graben 3 wird mit Siliciumdioxid 6 vor dem Ätzen des Grabens 4 aufgefüllt. Das Auffüllen des Grabens 4 erfolgt zunächst dadurch, daß eine thermische Oxidation durchgeführt wird, bei der eine Oxiddicke von etwa 50 bis 200 nm gebildet wird. Der restliche Teil des Grabens 4 wird durch Aufdampfen von Siliciumdioxid 7 aufgefüllt.

Die vorstehend kurz beschriebenen Verfahrensschritte sind beispielsweise im Einzelnen in der bereits genannten US Patentschrift Nr. 4 160 991 beschrieben. Auch das Einbringen der N⁺-leitenden Kollektorkontaktierungszone 13 durch Ionenimplantation erst angegeben.

Die nachfolgenden Verfahrensschritte weichen von dem bekannten Verfahren ab.

Auf die mit den abgesenkten Oxidzonen 6 und 7 ausgestattete Struktur werden übereinander eine erste Siliciumnitridschicht 8, eine erste Siliciumdioxidschicht 9, eine zweite Siliciumnitridschicht 10 und eine zweite Siliciumdioxidschicht 11 aufgebracht. Eine entsprechende Struktur ist in Fig. 2 dargestellt. Die erste Siliciumnitridschicht 8 weist vorzugsweise eine Dicke von etwa 100 nm auf. Die weiteren Schichten haben vorzugsweise eine Dicke von 50 nm. die Oxidschichten werden vorzugsweise auf pyrolitischem Wege bei 900 °C aufgebracht. Die Siliciumnitridschicht wird vorzugsweise bei einer Temperatur von etwa 800 °C niedergeschlagen. Auf bekanntem photolithographischem Wege werden die aufeinanderfolgenden Schichten 8, 9, 10 und 11 geätzt, so daß der später für den Basiskontakt vorgesehene Oberflächenbereich 12 der Epitaxieschicht 2 freigelegt wird. Es ist zu bemerken, daß der für die Kollektorkontaktierungszone 13 vorgesehene Oberflächenbereich der Epitaxieschicht 2 völlig von dem mit 14 bezeichneten Teil der aus den Schichten 8 bis 11 gebildeten Maskierungsschicht abgedeckt wird und so viel überlappt, daß bei dem anschließend am nicht abgeätzten Teil 17 der Maskierungsschicht durchzuführenden Unterätzungsprozeß der Oberflächenbereich 13 mit Sicherheit abgedeckt bleibt.

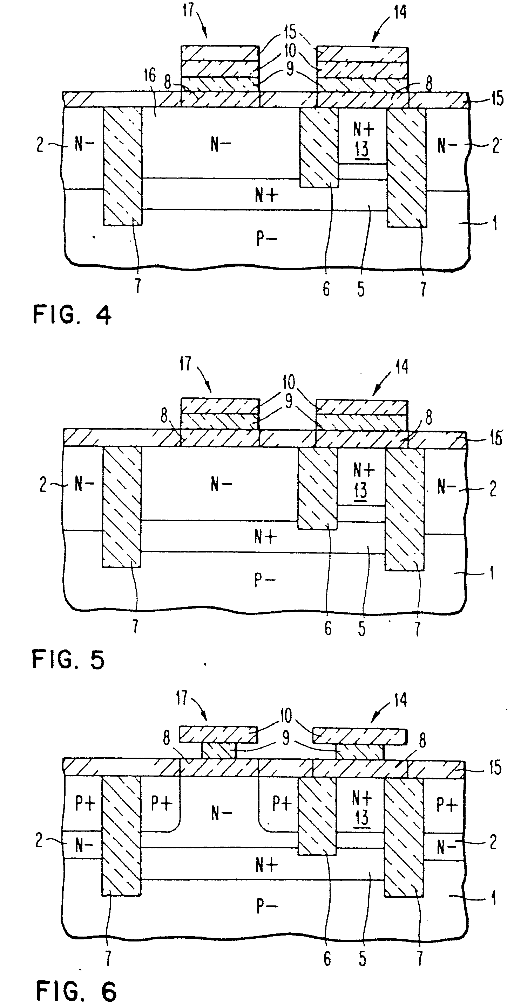

Nunmehr wird eine P-dotierte polykristalline Siliciumschicht 15 in einer Dicke von etwa 250 nm bei einer Temperatur von 650 °C mit einer Aufdampfrate von 10 nm/min aufgedampft, wie es in Fig. 4 dargestellt ist. Dabei schlägt sich das polykristalline Silicium nur auf den horizontalen Oberflächen nieder, nicht jedoch auf den vertikalen Seitenflächen der Schichten 9 und 10 der Maskierungsschicht. Ist die polykristalline Siliciumschicht 15 hoch dotiert, so wird der darunterliegende Basiskontaktbereich 16 der Epitaxieschicht 2 auf Grund der Ausdiffusion von Störstellen aus der polykristallinen Siliciumschicht ausreichend leitend. Eine Alternative bestünde darin, vor dem Aufbringen der polykristallinen Siliciumschicht 15 eine Implantation im Bereich dieses Basiskontaktbereiches 16 vorzunehmen.

Im nachfolgenden Verfahrensschritt wird die polykristalline Siliciumschicht 15 von den Oberflächen der Teile 14 und 17 der Maskierungsschicht entfernt. Dies kann dadurch geschehen, daß eine planare Schicht aus Photolack (nicht dargestellt) über die ungleichmäßige Oberfläche der polykristallinen Siliciumschicht 15 aufgeschleudert wird. Als Photolack verwendet man vorzugsweise Polyimid das bei reaktivem Ionenätzen mit CF₄ eine Ätzrate von etwa 40 nm/min aufweist, die vergleichbar mit der Ätzrate der polykristallinen Siliciumschicht 15 ist. Das bedeutet, daß beim Entfernen der Photolackschicht durch Ionenätzen die Struktur eben bleibt. Der Ätzvorgang wird abgestoppt, sobald die Siliciumnitridschicht 10 erreicht ist. Der restliche Photolack wird mit einem Lösungsmittel entfernt, so daß sich die in Fig. 5 dargestellte Struktur ergibt.

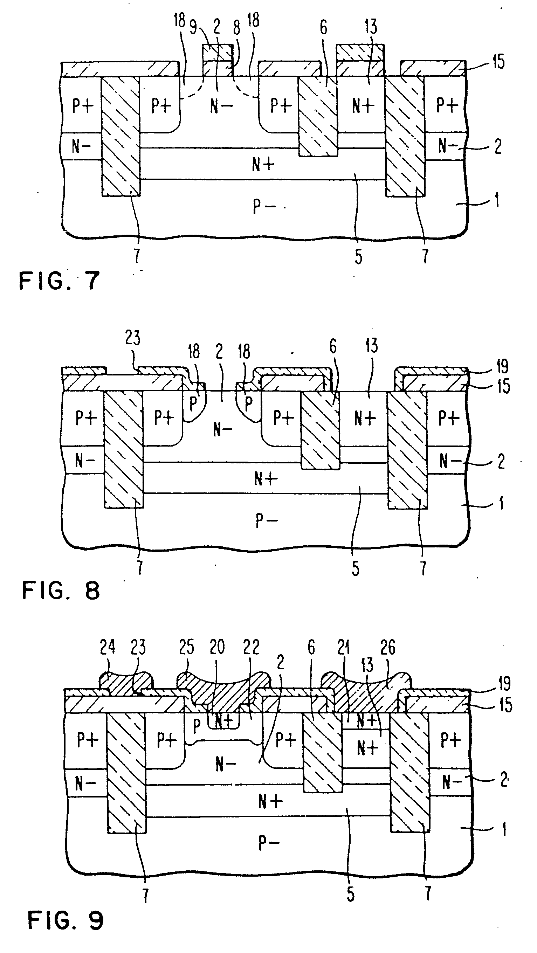

Der Teil 17 der Maskierungsschicht wird nunmehr unterätzt nach einem Verfahren wie es beispielsweise in « IEEE Transactions on Electron Devices », Vol. ED-25, No. 6, June 1978, p. 723 unter dem Titel « Sub-Half-Micrometer Emitter Width » beschrieben ist. Dabei wird die Siliciumdioxidschicht 9 unter Verwendung von gepufferter Flußsäure mit einer Ätzrate von etwa 100 nm/min lateral geätzt, bis der verbleibende Schichtrest der gewünschten Emitterweite entspricht. Die entstehende Struktur ist in Fig. 6 dargestellt. Im nächsten Verfahrensschritt wird die Siliciumnitridschicht 10 zusammen mit der Siliciumnitridschicht 8 entfernt, die durch das Unterätzen im Bereich der Siliciumdioxidschicht 9 freigelegt wurde. In den freigelegten Oberflächenbereich der Epitaxieschicht 15 wird nunmehr Bor implantiert, wodurch die extrinsische Basiszone 18 gebildet wird. Dieser Vorgang ist der Fig. 7 zu entnehmen. Vorzugsweise werden auf jeder Seite des Teiles 17 der Maskierungsschicht etwa 200 nm der Siliciumdioxidschicht 9 und der Siliciumnitridschicht 8 entfernt. Auf diese Weise reduziert man den Abstand zwischen Basis- und Emitterkontakt auf ein Minimum, wobei gleichzeitig eine ausreichende Dicke der zur Trennung der beiden Kontakte erforderlichen Siliciumdioxidschicht gewährleistet ist. Eine solche Siliciumdioxidschicht 19 mit einer Dicke von 100 bis 150 nm wird im nächsten Verfahrensschritt aufgebracht. Die noch verbliebenen Teile 17 und 14 der Maskierungsschicht werden nunmehr entfernt, so daß der Bereich der Emitterzone freigelegt wird, der zentral angeordnet und automatisch in Bezug auf die umgebende extrinsische Basiszone 18 ausgerichtet ist. Gleichzeitig wird der bereich der Kollektorkontaktierungszone freigelegt. Durch eine Implantation von N⁺-Störstellenmaterial wird nun die Emitterzone 20 und die Kollektorkontaktzone 21 eingebracht. Die entsprechende Struktur ist in Fig. 9 dargestellt. Schließlich wird die intrinsische Basiszone 22 in das Gebiet unterhalb der Emitterzone 20 implantiert. Dabei ist die Kollektorkontaktzone 21 in konventioneller Weise maskiert. Vervollständigt wird die Transistorstruktur durch Öffnen eines Basiskontaktfensters 23 in der Oxidschicht 19 und Bildung eines Basiskontaktes 24, eines Emitterkontaktes 25 und eines Kollektorkontaktes 26 durch konventionelle Metallisierung.

## Patentansprüche

1. Verfahren zum Herstellen einer bipolaren, vertikalen Transistorstruktur, bei dem in einem in einer Halbleiterschicht (2) durch Isolationszonen (7) abgegrenzten Bereich eine intrinsische Basiszone (22), eine diese lateral umgebende extrinsische Basiszone (18) und in der intrinsischen Basiszone (22) eine Emitterzone (20) verwirklicht werden, wobei die Emitterzone (20) direkt und die Basiszone (22) über eine dotierte, polykristalline Siliciumschicht (15) kontaktiert werden, dadurch gekennzeichnet, daß auf eine die Zonen des Transistors aufnehmenden Halbleiterschicht (2) eine aus mindestens einer ersten, unteren Schicht (8) und einer zweiten, oberen Schicht (9) unterschiedlichen Materials bestehende Maskierungsschicht aufgebracht wird, die nur den die extrinsische und intrinsische Basiszone (18, 22) umfassenden Oberflächenbereich den Halbleiterschicht (2) abdeckt, daß eine den nicht abgedeckten Oberflächenbereich und die Oberfläche der Maskierungsschicht (8, 9) bedeckende, entsprechend der Basiszone (22) dotierte polykristalline Siliciumschicht (15) aufgedampft wird, daß die polykristalline Siliciumschicht (15) von der Oberfläche der Maskierungsschicht (8, 9) entfernt wird, daß der sich über die geplante extrinsische Basiszone (18) erstreckende Teil der zweiten Schicht (9) entfernt wird, daß der entsprechende Teil der ersten Schicht (8) entfernt wird, daß in den freigelegten Bereich der Halbleiterschicht (2) die extrinsische Basiszone (18) eingebracht wird, daß der freigelegte Bereich mit einer Siliciumdioxidschicht (19) beschichtet wird, daß sämtliche restlichen Teile der Maskierungsschicht (8, 9) entfernt werden und daß in dem dabei freigelegten Bereich der Halbleiterschicht (2) die Emitterzone (20) eingebracht wird.

2. Verfahren nach Anspruch 1, dadurch gekennzeichnet, daß in den durch Isolationszonen (7) abgegrenzten Bereich der Halbleiterschicht (2) eine ebenfalls durch eine Isolationszone (6) abgegrenzte Kollektorkontaktierungszone (13) eingebracht wird und daß die Maskierungsschicht (8, 9) auch diesen Oberflächenbereich abdeckend aufgebracht wird.

3. Verfahren nach Anspruch 1 oder 2, dadurch gekennzeichnet, daß die Isolationszonen (7, 6) aus in die Halbleiterschicht (2) eingebrachten, abgesenkten Oxidzonen bestehen.

4. Verfahren nach Anspruch 3, dadurch gekennzeichnet, daß die Halbleiterschicht (2) aus einer auf ein Substrat (1) aufgebrachten Epitaxieschicht besteht, in der eine vergraben Subkollektorzone (5) angeordnet ist.

5. Verfahren nach den Ansprüchen 1 bis 4, dadurch gekennzeichnet, daß die intrinsische Basiszone (22) nach Einbringen der Emitterzone (20) durch Ionenimplantation hergestellt wird.

6. Verfahren nach den Ansprüchen 1 bis 5, dadurch gekennzeichnet, daß die Maskierungsschicht aus einer ersten Schicht (8) aus Siliciumnitrid und einer zweiten Schicht (9) aus Siliciumdioxid gebildet wird.

7. Verfahren nach den Ansprüchen 1 bis 6, dadurch gekennzeichnet, daß die Maskierungsschicht aus einer ersten, einer zweiten, einer dritten und einer vierten Schicht (8, 9, 10, 11) abwechselnden Materials gebildet wird.

8. Verfahren nach Anspruch 7, dadurch gekennzeichnet, daß der sich über die geplante extrinsische Basiszone (18) erstreckende Teil der zweiten Schicht (9) in der Maskierungsschicht durch laterales Unterätzen entfernt wird.

## Claims

1. Method of making a bipolar vertical transistor structure, where in a region limited in a semiconductor layer (2) by isolation areas (7) an intrinsic base region (22), an extrinsic base region (18) laterally surrounding it, and in the intrinsic base region (22) an emitter region (20) are realized, the emitter region (20) being in direct contact, and the base region (22) being contacted via a doped polycristalline silicon layer (15), characterized in that onto a semiconductor layer (2) receiving the transistor areas a masking layer consisting of at least one first lower layer (8) and one second upper layer (9) of different material is applied which covers only that surface portion of the semiconductor layer (2) which comprises the extrinsic and intrinsic base region (18, 22), that a polycrystalline silicon layer (15), covering the uncovered surface portion and the surface of the masking layer (8, 9) and being doped in accordance with the base region (22) is evaporated, that the polycristalline silicon layer (15) is removed from the surface of the masking layer (8, 9), that portion of the second layer (9) which extends over the planned extrinsic base region (18) is removed, that the corresponding part of the first layer (8) is removed, that the extrinsic base region (18) is provided in the exposed region of the semiconductor layer (2), that the exposed region is coated with a silicon dioxide layer (19), that all remaining portions of the masking layer (8, 9) are removed, and that in the thus exposed region of the semiconductor layer (2) the emitter region (20) is provided.

2. Method as claimed in claim 1, characterized in that in that portion of the semiconductor layer (2) which is limited by isolation areas (7) a collector contacting area (13) equally limited by an isolation area (6) is provided, and that the masking layer (8, 9) is applied in such a manner that it covers also this surface portion.

3. Method as claimed in claim 1 or 2, characterized in that the isolation areas (7, 6) consist of recessed oxide areas formed in the semiconductor layer (2).

4. Method as claimed in claim 3, characterized in that the semiconductor layer (2) consists of an epitaxial layer applied on a substrate and comprising a buried subcollector region (5).

5. Method as claimed in any one of claims 1 to 4, characterized in that the intrinsic base region (22) is made after emitter region (20) has been introduced through ion implantation.

6. Method as claimed in any one of claims 1 to 5, characterized in that the masking layer is formed of a first layer (8) of silicon nitride and a second layer (9) of silicon dioxide.

7. Method as claimed in any one of claims 1 to 6, characterized in that the masking layer is formed of a first, a second, a third and a fourth layer (8, 9, 10, 11) of alternate material.

8. Method as claimed in claim 7, characterized in that portion of the second layer (9) which extends over the planned extrinsic base region (18) is removed in the masking layer by lateral sub-etching.

**Revendications**

1. Procédé de fabrication d'une structure de transistor bipolaire, verticale où on réalise une zone de base intrinsèque (22), une zone de base (18) extrinsèque disposée latéralement sur le contour de cette dernière zone, dans une région d'une couche semiconductrice (2) délimitée par dez zones d'isolation (7) et une zone émetteur (20) dans ladite zone de base intrinsèque (22), où le contact est établi directement avec ladite zone émetteur (20) et à travers une couche de silicium polycristalline (15) dopée avec ladite zone de base (22), caractérisé en ce qu'une couche de masquage, constituée d'au moins une première couche inférieure (8) et une seconde couche supérieure (9) composées d'un matériau différent, est disposée sur une couche semiconductrice (2) comportant les zones du transistor, laquelle couche de masquage recouvre seulement la région de surface de ladite couche semiconductrice (2) contenant lesdites zones extrinsèque et intrinsèque (18, 22), en ce qu'une couche de silicium (15) polycristalline dopée comme la zone de base (22) est déposée en phase vapeur sur la région de surface non recouverte et à la surface de ladite couche de masquage (8, 9), en ce que ladite couche de silicium polycristalline (15) est enlevée de la surface de ladite couche de masquage (8, 9), en ce que la partie de ladite seconde couche (9) qui s'étend sur la zone de base extrinsèque (18) est enlevée, en ce que la partie qui correspond à la première couche (8) est enlevée, en ce que la zone de base (18) extrinsèque est introduite dans la région découverte de ladite couche semiconductrice (2) en ce qu'une couche de dioxide de silicium (19) est déposée sur cette région découverte, en ce que toutes les autres parties de ladite couche de masquage (8, 9) sont enlevées, en ce que ladite zone d'émetteur (20) est introduite dans la région ainsi découverte de ladite couche semiconductrice (2).

2. Procédé selon la revendication 1, caractérisé en ce qu'une zone de contact du collecteur (13) elle-aussi délimitée par une zone d'isolation (6) est introduite dans ladite région de la couche semiconductrice (2) délimitée par des zones d'isolation (7) et, en ce que ladite couche de masquage (8, 9) est aussi déposée pour recouvrir toute la région de surface.

3. Procédé selon la revendication 1 ou 2, caractérisé en ce que lesdites zones d'isolation (7, 6) sont des zones d'oxide encastrées introduites dans ladite couche semiconductrice (2).

4. Procédé selon la revendication 3, caractérisé en ce que ladite couche semiconductrice (2) est une couche épitaxiale déposée sur un substrat (1) dans laquelle est disposée une zone de sous-collecteur (5) encastrée.

5. Procédé selon les revendications 1 à 4, caractérisé en ce que ladite zone de base intrinsèque (22) est fabriquée par implantation ionique après introduction de ladite couche émetteur (20).

6. Procédé selon les revendications 1 à 5, caractérisé en ce que ladite couche de masquage est formée d'une première couche (8) de nitrure de silicium et d'une seconde couche (9) de dioxide de silicium.

7. Procédé selon les revendications 1 à 6, caractérisé en ce que ladite couche de masquage est formée d'une première, d'une deuxième, d'une troisième et d'une quatrième couche (8, 9, 10, 11) composées d'un matériau alternativement différent.

8. Procédé selon la revendication 7, caractérisé en ce que la partie de ladite deuxième couche (9) qui s'étend sur la zone de base extrinsèque (18) est enlevée de ladite couche de masquage par attaque latérale sous-jacente.

FIG. 1

FIG. 2

FIG. 3

1

**FIG. 4**

**FIG. 5**

**FIG. 6**

FIG. 7

FIG. 8

FIG. 9